# FASCICULE DE BREVET EUROPEEN

(11) **EP 2 372 335 B1**
(45) Date de publication et mention de la délivrance du brevet: **07.11.2012**
(21) Numéro de dépôt: 11001618.5
(22) Date de dépôt: 28.02.2011
(51) Int. Cl.: G01M 99/00, G01R 31/28, G06F 11/26, H04M 1/24

(54) **Banc de test d'un équipement muni d'une pluralité de boutons et d'un écran de visualisation**
Prüfstand einer Anlage, die mit einer Vielzahl von Knöpfen und einem Anzeigebildschirm ausgestattet ist
Test bench of a device provided with a plurality of buttons and a display screen

(30) Priorité: 30.03.2010 ES 201000466
(43) Date de publication de la demande: 05.10.2011
(73) Titulaire: Eurocopter Espagne, Albacete (ES)
(72) Inventeur: Ciudad Ceprian, Oscar, Parque Aeronautico y logistico Albacete (ES); Antic, Slaven, Parque Aeronautico y logistico Albacete (ES); Castillo Garcia, Fernando José, 13071 Ciudad Real (ES); Sanchez Rodriguez, Luis, 13071 Ciudad Real (ES); Hungria Diaz del Castillo, Pedro Antonio, 13071 Ciudad Real (ES); Ramos de la Flor, Francisco, 13071 Ciudad Real (ES); Feliu Batlle, Vicente, 13071 Ciudad Real (ES)
(74) Mandataire: GPI & Associés

(56) Documents cités:
- EP-A1- 1 713 239
- JP-A- 56 089 066
- JP-A- 61 100 824
- US-A1- 2009 030 642
- US-A1- 2009 312 009

## Description

La présente invention concerne un banc de test d'un équipement électronique muni d'une pluralité de boutons et d'un écran de visualisation.

L'invention se situe dans le domaine des moyens d'essais d'équipements électroniques, et plus particulièrement un équipement d'aéronef.

En effet, il est courant de tester un équipement électronique avant de le mettre en service. Un tel équipement comporte un écran de visualisation et une pluralité de boutons commandant l'affichage de données prédéterminées sur l'écran de visualisation. Par exemple, l'équipement est un équipement d'hélicoptère dénommé « Control and Display Unit » en langue anglaise et connu sous l'acronyme CDU.

Afin de tester l'équipement, on manoeuvre chaque bouton et on vérifie qu'il en résulte l'affichage des données requises sur l'écran de visualisation.

Ce processus de test de l'équipement peut être réalisé manuellement par un opérateur. Toutefois, une vérification manuelle n'est pas compatible avec une fabrication industrielle dans la mesure où elle génère des coûts importants.

Pour automatiser le test, on utilise alors un banc de test muni d'un actionneur mécanique apte à manoeuvrer les boutons de l'équipement et d'un moyen de surveillance optique, une caméra braquée sur l'écran de visualisation associée à un organe de contrôle de type processeur. Dès lors, l'actionneur manoeuvre un bouton et le moyen de surveillance optique vérifie que l'écran de visualisation affiche les données requises. Plus précisément, la caméra envoie une image réelle de l'écran de visualisation à l'organe de contrôle, cet organe de contrôle comparant alors l'image réelle avec une image théorique préprogrammée inscrite dans sa mémoire.

Le document JP6324121 présente un tel banc de test.

L'état de la technique inclut aussi les documents US2009/312009A1, JP61100824A, JP56089066A, EP1713239A1 et US2009/030642A1.

Le document US2009/312009 présente un banc muni de moyens motorisés pour déplacer un doigt.

Le document JP61100824 décrit un robot comprenant un bras articulé et non pas un bras rotatif.

Le document JP56089066 montre un système incluant un plateau coulissant sur des rails.

Le document EP1713239 présente un moyen de test d'un téléphone cellulaire.

Le document US2009/030642 montre un banc comprenant deux montants supportant un rail portant un arbre.

Bien qu'efficace, on constate qu'il est néanmoins impossible de contrôler de manière automatique un banc d'essais muni de boutons réparties de part et d'autre de l'écran de visualisation. En effet, les bras portant l'actionneur des boutons passent alors devant l'écran de visualisation et empêche le moyen de surveillance optique de contrôler les données affichées

La présente invention a alors pour objet de proposer un banc de test d'un équipement électronique muni d'une pluralité de boutons et d'un écran de visualisation, ce banc étant apte à manoeuvrer l'ensemble des boutons en ne masquant pas l'écran de visualisation.

Selon l'invention, un banc de test d'un équipement muni d'une pluralité de boutons et d'un écran de visualisation comporte un moyen de surveillance optique fixe de données affichées sur l'écran de visualisation, et un organe de contrôle relié au moyen de surveillance optique. Cet organe de contrôle peut être muni d'un processeur, d'une mémoire et de moyens d'interface de type clavier permettant à un opérateur d'ordonner un test.

De plus, le banc de test est notamment remarquable en ce qu'il comporte une barre mobile dans un plan en regard de l'équipement apte à être déplacée selon une direction longitudinale perpendiculaire à cette barre mobile par un moyen de déplacement longitudinal, le banc ayant de plus un chariot mobile soutenu par la barre mobile par un moyen de déplacement transversal apte à déplacer le chariot le long de la barre mobile dans le plan. Le banc est aussi pourvu d'un bras rotatif et d'un moyen de déplacement rotatif pour faire tourner le bras rotatif autour d'un axe de rotation perpendiculaire audit plan, un actionneur des boutons de l'équipement étant solidaire en rotation du bras rotatif autour de l'axe de rotation.

Ainsi, le moyen de déplacement longitudinal déplace l'actionneur via la barre mobile, le chariot et le bras rotatif selon une direction longitudinale perpendiculaire à la barre mobile. Le moyen de déplacement longitudinal peut comporter une première vis sans fin secondaire entraînée par un premier moteur, la première vis sans fin secondaire coopérant avec un premier organe fileté de la barre mobile.

De plus, le moyen de déplacement transversal déplace l'actionneur via la barre mobile, le chariot et le bras rotatif selon une direction transversale parallèle à la barre mobile. Le moyen de déplacement transversal peut comporter une deuxième vis sans fin secondaire entraînée par un deuxième moteur, la deuxième vis sans fin secondaire coopérant avec un deuxième organe fileté du chariot. Par exemple, la deuxième vis sans fin secondaire est agencée dans la barre mobile, cette barre mobile comportant une glissière transversale dans laquelle coulisse le chariot.

Les premier et deuxième moteurs sont éventuellement commandés par l'organe de contrôle du banc.

Par suite, l'actionneur se déplace dans un plan surplombant l'équipement à tester.

De plus, cet actionneur peut effecteur une rotation autour d'un axe de rotation.

Le banc d'essai permet par suite de ne jamais obturer le champ de vision du moyen de surveillance optique fixe, une caméra vidéo par exemple. En effet, si la barre mobile vient à obturer ce champ de vision, l'organe de contrôle requiert un déplacement de la barre mobile et une rotation de l'actionneur.

Pour tester un équipement donné, il est possible de préprogrammer une séquence de test dans l'organe de contrôle qui positionne l'actionneur dans des positions prédéterminées. Selon une variante manuelle, un opérateur commande le banc de test en utilisant un moyen d'interface de l'organe de contrôle.

Par ailleurs, l'invention peut inclure une ou plusieurs des caractéristique suivantes.

Ainsi selon un aspect de l'invention, le bras rotatif est fixé à un support, le banc comportant un moyen de translation pour faire coulisser le support sur le chariot selon une direction de coulissement parallèle à l'axe de rotation.

Par exemple, le moyen de translation comporte un troisième moteur et une troisième vis sans fin secondaire disposée dans le chariot, la troisième vis sans fin secondaire coopérant avec un troisième organe fileté du support. Le troisième moteur est éventuellement commandé par l'organe de contrôle du banc

Désormais, l'actionneur peut non plus se déplacer dans un plan mais dans un espace à trois dimensions ce qui facilite l'opération d'activation des boutons.

Un mouvement dans un plan restreint l'emploi d'un actionneur pour manoeuvrer des boutons à bascule alors qu'un mouvement dans un espace tridimensionnel permet de manoeuvrer tout type de boutons.

En outre, le banc de test peut comporter un premier montant fixe de maintien latéral perpendiculaire à la barre mobile et un deuxième montant fixe latéral perpendiculaire à la barre mobile, une première extrémité de la barre mobile coulissant sur le premier montant fixe et une deuxième extrémité de la barre mobile coulissant sur le deuxième montant fixe, le moyen de déplacement longitudinal déplaçant la barre mobile par rapport aux premier et deuxième montants fixes selon ladite direction longitudinale.

Par conséquent, le moyen de déplacement longitudinal peut comporter une première vis sans fin secondaire disposée dans un montant fixe de maintien latéral, les premier et deuxième montants ayant des glissières de guidage.

Selon un autre aspect, l'actionneur comporte un bras allongé solidarisé au bras rotatif, le bras allongé portant un carter cylindrique muni d'une pluralité de pinces mobiles par rapport au carter, un premier moyen d'entraînement commandant la mobilité des pinces par une vis sans fin principale s'étendant le long d'un axe de symétrie du carter et un deuxième moyen d'entraînement commandant une rotation du carter et des pinces autour dudit axe de symétrie.

Le bras allongé porte favorablement le premier moyen d'entraînement et le deuxième moyen d'entraînement. De plus, le carter est inséré dans un orifice de fixation du bras allongé.

On comprend que les premier et deuxième moyens d'entraînement sont commandés par l'organe de contrôle du banc.

Ainsi, l'actionneur permet d'appuyer à l'aide de ces pinces sur un bouton. De plus, cet actionneur peut se saisir d'un bouton rotatif à l'aide de ces pinces, optionnellement réparties de manière équidistante sur une périphérie du carter et faire tourner le bouton via le deuxième moyen d'entraînement.

En effet, le premier moyen d'entraînement met en rotation la vis sans fin principale selon un premier sens ce qui provoque une rotation de chaque pince par rapport au carter. Les pinces décrivent un cône ouvert pouvant accueillir un bouton rotatif en son sein.

Lorsque les pinces entourent le bouton rotatif, le premier moyen d'entraînement met en rotation la vis sans fin principale selon un deuxième sens contraire au premier sens afin que les pinces serrent le bouton rotatif.

Le deuxième moyen d'entraînement met alors en rotation le carter et les pinces conjointement ce qui génère une rotation du bouton rotatif.

Par ailleurs, chaque pince peut être articulée d'une part au carter par un axe de basculement et, d'autre part, à un bras radial d'un moyeu fileté coulissant le long de la vis sans fin principale par un axe de commande. Une rotation de la vis sans fin principale entraîne alors une translation du moyeu fileté le long de la vis sans fin principale et par suite une rotation de chaque pince autour de son axe de basculement.

Favorablement, l'axe de commande d'une pince est disposé dans un orifice oblong ménagé dans une première zone extrémale de la pince concernée.

Par ailleurs, chaque pince comporte un moyen de préhension articulé à une deuxième zone extrémale de la pince, tel qu'un patin par exemple.

En outre, le carter comporte un engrenage inférieur en prise avec ledit deuxième moyen d'entraînement, la vis sans fin principale traversant l'engrenage inférieur, la vis sans fin principale et l'engrenage inférieur étant libres d'effectuer un mouvement indépendamment l'un de l'autre.

L'invention et ses avantages apparaîtront avec plus de détails dans le cadre de la description qui suit avec des exemples de réalisation donnés à titre illustratif en référence aux figures annexées qui représentent :
- la figure 1, un banc de test selon une première variante,
- la figure 2, un banc de test selon une deuxième variante,
- les figures 3 à 6, des vues explicitant le fonctionnement du banc,
- la figure 7, une vue d'un actionneur, et
- la figure 8 une vue montrant une pince de l'actionneur.

Les éléments présents dans plusieurs figures distinctes sont affectés d'une seule et même référence.

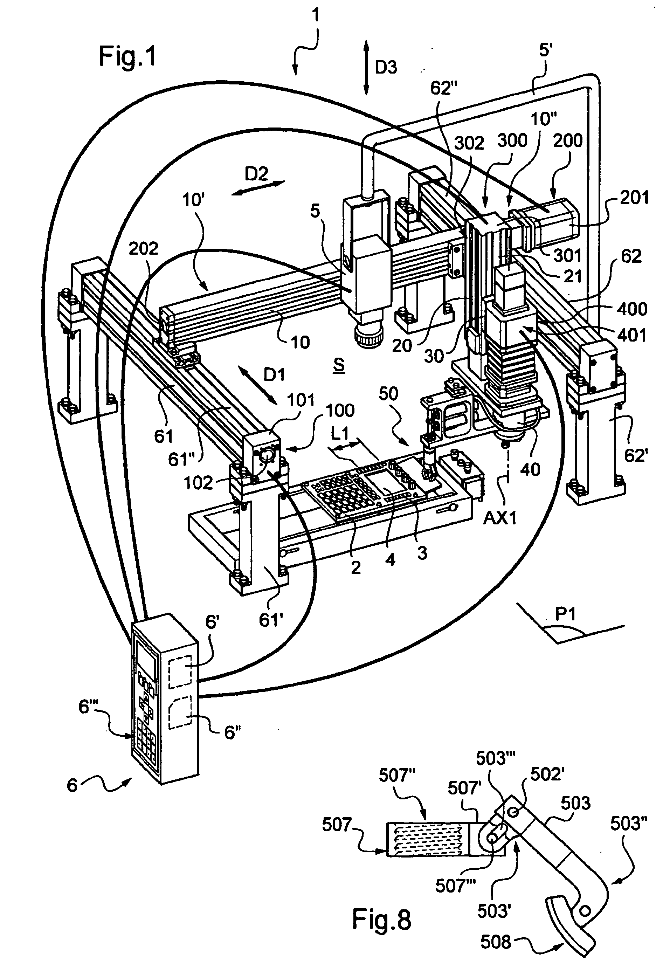

La figure 1 présente un banc 1 de test d'un équipement 2 électronique, cet équipement 2 possédant un écran de visualisation 4 et une pluralité de boutons 3 de commande. L'écran de visualisation s'étend sur une première longueur L1 selon une direction dite direction longitudinale D1.

Afin de pouvoir tester le bon fonctionnement de l'équipement, le banc 1 comprend un moyen de surveillance optique 5 à savoir une caméra vidéo dirigée sur l'écran de visualisation 4. Le moyen de surveillance optique 5 est alors relié électriquement à un organe de contrôle 6 du banc 1.

Cet organe de contrôle 6 peut avoir un processeur 6', une mémoire 6" et des moyens d'interface homme-machine 6"'. Pour déterminer le bon fonctionnement de l'équipement 2, le processeur 6' compare l'image réelle prise par le moyen de surveillance optique 5 avec une image prédéterminée stockée dans la mémoire 6". Si les images réelle et prédéterminée sont identiques alors l'équipement fonctionne correctement.

Cependant pour faire apparaître une image sur l'écran de visualisation, il convient de manoeuvrer les boutons 3 de l'équipement 2, chaque bouton requérant l'affichage d'une page prédéterminée de données sur l'écran de visualisation 4.

A cet effet, le banc 1 comporte un actionneur 50 apte à manoeuvrer chaque bouton, selon une séquence prédéterminée stockée dans la mémoire 6" par exemple. L'actionneur 50 est alors relié à l'organe de contrôle 6, cet organe de contrôle demandant à l'actionneur d'agir sur un bouton 3 au moment requis.

Par suite, le banc 1 est muni de moyens de déplacement de l'actionneur 50.

En effet, le banc 1 est muni d'une barre mobile 10 supportant un chariot 20, ce chariot 20 portant un bras rotatif 40 solidarisé à l'actionneur 50. L'ensemble comprenant la barre mobile 10, le chariot 20, le bras rotatif 40 et l'actionneur 50 est alors en regard de l'équipement 2, en surplombant cet équipement 2.

La barre mobile 10 est avantageusement perpendiculaire à la direction longitudinale D1. Ainsi, la barre mobile 10 peut être déplacée selon la direction longitudinale D1 dans un plan P1 par un moyen de déplacement longitudinal 100.

Selon une variante, la barre mobile 10 repose sur un premier montant 61 et un deuxième montant 62 fixes de maintien latéral perpendiculaire à la barre mobile 10, et donc dirigés selon des directions parallèles à la direction longitudinale D1. Dès lors, une première extrémité 10' de la barre mobile 10 coulisse dans une première glissière 61" du premier montant 61, et une deuxième extrémité 10" de la barre mobile 10 coulisse dans une deuxième glissière 62" du deuxième montant 62.

Le moyen de déplacement longitudinal 100 de la barre mobile 10 comprend alors un premier moteur de translation 101 fixé par exemple au premier montant 61, et une première vis sans fin secondaire 102 agencée dans le premier montant 61. Cette première vis sans fin secondaire 102 coopère avec un écrou solidaire de la première extrémité 10' de la barre mobile 10, et non représenté sur la figure par commodité. Le premier moteur de translation est relié électriquement à l'organe de contrôle 6 qui peut ainsi requérir une translation de la barre mobile 10 selon la direction longitudinale D1.

Par ailleurs, la barre mobile 10 est équipée du moyen de déplacement transversal 200 du chariot 20, ce chariot 20 coulisse selon une direction transversale D2 orthogonale à la direction longitudinale D1 et contenue dans le plan P1.

Le moyen de déplacement transversal 200 comprend par exemple un deuxième moteur de translation 201 fixé à la barre mobile 10, et une deuxième vis sans fin secondaire 202 agencée à l'intérieur de la barre mobile et engrenée au deuxième moteur de translation 201. La deuxième vis sans fin secondaire 202 coopère avec un écrou solidaire du chariot 20, et non représenté sur la figure par commodité, afin que ce chariot se déplace dans une glissière de la barre mobile 10. Le deuxième moteur de translation est relié électriquement à l'organe de contrôle 6 qui peut ainsi requérir une translation du chariot 20 selon la direction transversale D2.

Or, l'actionneur 50 est relié au chariot 20 par au moins un bras rotatif 50. En manoeuvrant la barre mobile 10 et le chariot 20, l'organe de contrôle déplace finalement l'actionneur 50 dans un plan.

De plus, le banc comporte un moyen de déplacement rotatif 400 apte à faire tourner le bras rotatif 40, et donc l'actionneur 50 autour d'un axe de rotation AX1 perpendiculaire au plan P1.

Ce moyen de déplacement rotatif 400 comprend un moteur rotatif 401 engrenant le bras rotatif 40 afin de le mettre en rotation.

Le moteur rotatif 40 peut être solidarisé au chariot 20.

Cependant, il est avantageux que le bras rotatif soit à même d'être translaté le long de l'axe de rotation AX1. Ainsi, en référence à la figure 1, le bras rotatif 40 est fixé à un support 30 apte à coulisser sur le chariot 20 selon une direction de coulissement D3 perpendiculaire au plan P1 et parallèle à l'axe de rotation AX1.

Le banc comporte alors un moyen de translation 300 muni d'un troisième moteur de translation 301 fixé au chariot 20 et d'une troisième vis sans fin secondaire 302 agencée dans le chariot 20.. Le troisième moteur de translation 301 est relié à l'organe de contrôle 6.

Sur ordre de l'organe de contrôle 6, la troisième vis sans fin secondaire 302 coopère avec un écrou du support 30 afin que ce support coulisse selon la direction de coulissement D3 dans une glissière 21 du chariot 20.

Le bras rotatif 40 peut alors être directement fixé au support 30 ou via le moteur rotatif 401, l'ensemble comportant le support 30 et le moteur rotatif 401 formant par exemple un même organe mécanique.

On note que selon le premier mode de réalisation de la figure 1, l'équipement 2 repose sur un premier support S horizontal, tel qu'un sol, une table, un socle, ou un tapis roulant par exemple. De même, les premier et deuxième montants 61, 62 et le moyen de surveillance optique 5 reposent sur un support horizontal via des pieds 61', 62', 5'.

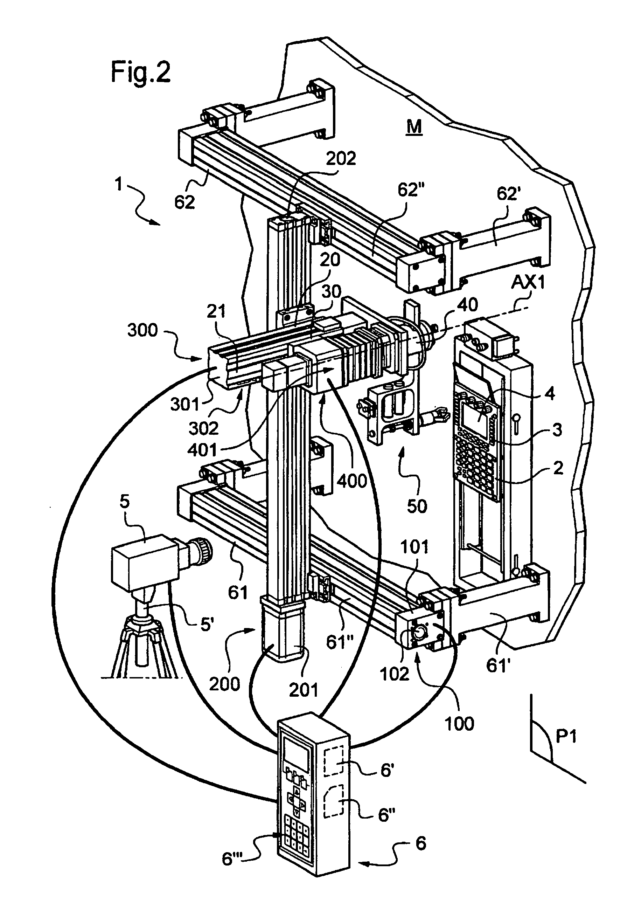

Selon le deuxième mode de réalisation de la figure 2, l'équipement 2 repose sur un deuxième support M sensiblement vertical, tel qu'un mur ou un socle vertical par exemple. Dès lors, les premier et deuxième montants 61, 62 sont fixés à ce deuxième support M via des pieds 61', 62, alors que le moyen de surveillance optique 5 repose sur un support horizontal via un trépied 5'.

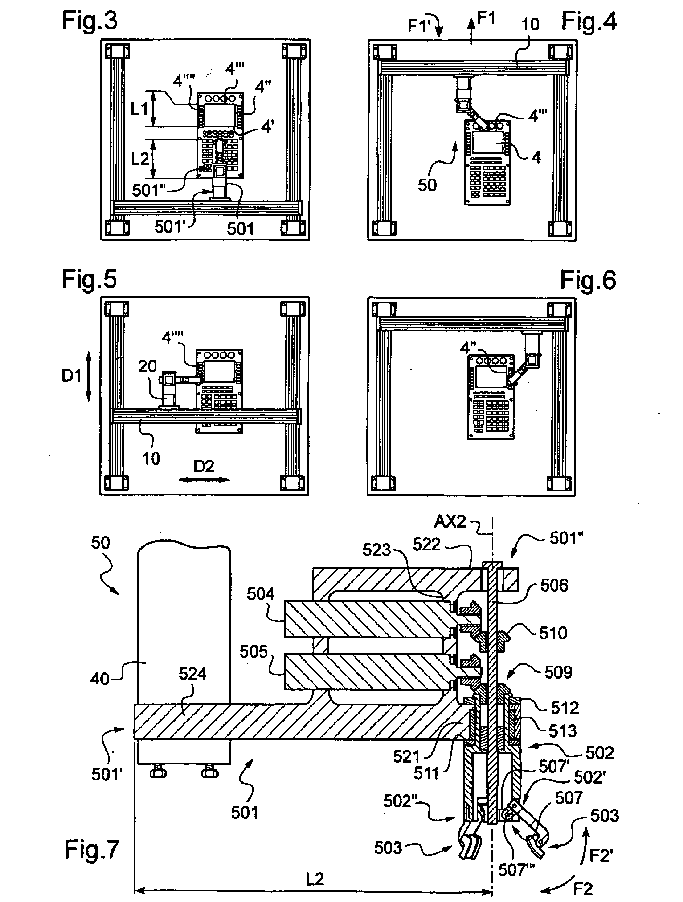

Les figures 3 à 6 explicitent le fonctionnement du banc de test 1. Sur ces figures, l'équipement 2 à tester comporte un écran de visualisation 4 muni d'une face inférieure 4' en regard d'une face supérieure 4"', et d'une face latérale droite 4" en regard d'une face latérale gauche 4"".

En référence à la figure 3, l'actionneur 50 active un bouton inférieur situé contre la face inférieure 4'. Par commodité, on considère que l'actionneur se trouve dans une position initiale. On note que l'actionneur 50 comporte un bras allongé s'étendant d'une première extrémité 501' vers une deuxième extrémité 501" selon une deuxième longueur L2, au moins égale à la moitié de la première longueur L1.

La première extrémité 501' est dénommée « extrémité proximale » par commodité dans la mesure où elle est solidarisée au bras rotatif, alors qu'au contraire, la deuxième extrémité 501" est dénommée « extrémité distale ».

En référence à la figure 4, pour manoeuvrer un bouton supérieur situé contre la face supérieure 4"', l'organe de contrôle ordonne une translation de la barre mobile 10 selon la direction longitudinale D1 suivant la flèche F1. Si l'organe de contrôle réagit à ce seul ordre, la barre mobile se trouvera en vis-à-vis de l'écran de visualisation 4.

Dès lors, l'organe de contrôle requiert une rotation du bras rotatif et de l'actionneur 50 selon la flèche F1' pour que la barre mobile 10 se trouve dans une position ne perturbant pas le déroulement du test.

En référence à la figure 5, en partant de la position initiale pour atteindre un bouton latéral gauche, l'organe de contrôle ordonne un déplacement de la barre mobile 10 selon la direction longitudinale D1, un déplacement du chariot 20 selon la direction transversale D2, et une rotation du bras rotatif. De même, en référence à la figure 6, en partant de la position initiale pour atteindre un bouton latéral droit, l'organe de contrôle ordonne un déplacement de la barre mobile 10 selon la direction longitudinale D1, un déplacement du chariot 20 selon la direction transversale D2, et une rotation du bras rotatif.

On comprend que pour manoeuvrer un bouton, à savoir pour que l'actionneur appuie sur un bouton ou se saisisse d'un bouton rotatif, l'organe de contrôle requiert éventuellement un coulissement du bras rotatif selon la direction de coulissement.

La figure 7 présente un actionneur 50 conforme à l'invention.

L'actionneur 50 comprend donc un bras allongé 501 s'étendant sur une deuxième longueur L2 d'une extrémité proximale 501' solidarisée au bras rotatif 40 vers une extrémité distale 501".

L'extrémité distale comporte une chape en forme de U munie d'une joue inférieure 521, d'une joue supérieure 522 et d'un socle 523. La joue inférieure 521 est alors dans le prolongement d'un barreau longiligne 524 du bras allongé, ce barreau longiligne étant solidarisé au bras rotatif 40.

Le bras allongé 501 portant un carter 502, la base du carter 502 est agencée dans un orifice ménagé dans la joue inférieure 521.

Un palier 513 est alors disposé entre la joue inférieure 521 et le carter 502.

De plus, la base du carter 502 comporte des bagues de protection 511, 512, ces bagues étant emmanchées en force autour de la dite base du carter. Le bagues de protection sont disposées de part et d'autre de la joue inférieure 521 de manière à éviter une friction potentiellement destructive entre le carter 502 et la joue inférieure 521.

L'extrémité libre du carter 502 est alors munie de pinces 503 réparties de manière équidistante sur la périphérie 502" de cette extrémité libre.

Plus précisément, le carter 502 et muni de fentes dans lesquelles sont engagées les pinces 503, chaque pince étant fixée à une fente par un axe de basculement 502'. Dès lors, chaque pince est mobile par rapport au carter 502, chaque pince pouvant s'écarter en décrivant un arc de cercle par rapport au carter 502 par exemple

En outre, l'actionneur 50 comporte une vis sans fin principale 506 traversant la joue supérieure 522 et la joue inférieure 521. Plus précisément, cette vis sans fin principale 506 traverse le carter 502, la vis sans fin principale étant dirigée selon un axe de symétrie AX2 du carter 502.

Un palier 514 est de plus disposé entre la vis sans fin principale 506 et une paroi interne de la base du carter 502.

La vis sans fin principale 506 coopère à l'intérieur de l'extrémité libre du carter 502 avec un moyeu fileté 507.

En référence à la figure 8, chaque pince 503 est articulée à un bras radial 507' de ce moyeu fileté 507 par un axe de commande 507"'. En effet, chaque pince s'étendant d'une première zone extrémale 503 vers une deuxième zone extrémale 503", la première zone extrémale 503' comporte un orifice oblong 503"' dans lequel est inséré l'axe de commande 507"'.

On note que pour pouvoir basculer autour de l'axe de basculement 502', cet axe de basculement 502' est agencé entre la première zone extrémale 503' reliée au moyeu fileté 507 et la deuxième zone extrémale 503".

Par ailleurs, chaque pince 503 comporte un moyen de préhension508, tel qu'un patin, articulé à la deuxième zone extrémale 503".

Dès lors, la vis sans fin principale 506 coopère avec un filetage interne 507" du moyeu fileté 507. Une rotation de la vis sans fin principale 506 autour de l'axe de symétrie AX2 provoque donc une translation du moyeu fileté 507, et par suite une rotation de chaque pince 503 autour de son axe de basculement 502'.

En référence à la figure 7, pour commander la rotation de la vis sans fin principale 506, l'actionneur 50 comporte un premier moyen d'entraînement 504, à savoir un moteur fixé au socle 523 de la chape du bras allongé 501. Ce premier moyen d'entraînement 503 engrène un pignon supérieur 510 solidaire de la vis sans fin principale 506. Le premier moyen d'entraînement 504 est relié électriquement à l'organe de contrôle 6 du banc.

Lorsque ce premier moyen d'entraînement 504 est mis en rotation, il génère une rotation de la vis sans fin principale 506. En fonction du sens de rotation de la vis sans fin principale 506, le moyeu fileté se rapproche de la joue inférieure 521 ce qui induit une fermeture des pinces selon la flèche F2 qui se rapprochent les unes des autres, ou s'éloignent de la joue inférieure 521 ce qui induit une ouverture des pinces selon la flèche F2 qui s'éloignent les unes des autres.

Le mouvement de fermeture des pinces permet à l'actionneur de se saisir d'un bouton d'un équipement à tester.

Pour tourner ce bouton, l'actionneur 50 est pourvu d'un deuxième moyen d'entraînement 505 commandant une rotation 5 conjointe dudit carter 502 et desdites pinces 503 autour de l'axe de symétrie AX2. Ce deuxième moyen d'entraînement 505 est par exemple un moteur fixé au socle 523 de la chape du bras allongé 501, ce moteur étant en prise avec un pignon inférieur 509 solidarisé au carter par des moyens usuels.

On remarque que la vis sans fin principale 506 traverse le pignon inférieur 509. Toutefois, la vis sans fin principale 506 et le pignon inférieur 509 ne sont pas en contact direct afin de ne pas être solidaire en rotation. Un palier peut être prévu entre le pignon inférieur et la vis sans fin principale.

Sous l'impulsion d'un organe de contrôle 6 auquel il est relié, le deuxième moyen d'entraînement 505 génère alors une rotation des pinces via successivement le pignon inférieur 509, le carter 502.

Cependant, on note qu'un tel processus va engendrer un déplacement du moyeu fileté 507, et donc une ouverture ou une fermeture des pinces. Pour éviter une telle ouverture ou fermeture, l'organe de contrôle ordonne au premier moyen d'entraînement 504 de tourner à la même vitesse que le deuxième moyen d'entraînement 505 afin de maintenir le moyeu fileté 507 dans une position donnée.

De manière ingénieuse est innovante, le mouvement rotatif du carter et des pinces autour de l'axe de symétrie AX2 n'engendre pas ni un blocage ni un relâchement des pinces. L'emploi de deux moyens d'entraînement est donc possible contrairement aux idées traditionnellement reçues.

Naturellement, la présente invention est sujette à de nombreuses variations quant à sa mise en oeuvre. Bien que plusieurs modes de réalisation aient été décrits, on comprend bien qu'il n'est pas concevable d'identifier de manière exhaustive tous les modes possibles. Il est bien sûr envisageable de remplacer un moyen décrit par un moyen équivalent sans sortir du cadre de la présente invention.

En effet, on comprend que le banc de test présenté peut comprendre des moyens de traitement de l'essai réalisé, tels que par exemple des alarmes qui se déclenchent en cas de défaut, des moyens de mémorisation des résultats de l'essai à savoir de la comparaison entre les images réelles prises par le moyen de surveillance optique des images prédéterminées, ou encore des moyens de transmission desdits résultats à un organe externe.

## Revendications

1. Banc (1) de test d'un équipement (2) muni d'une pluralité de boutons (3) et d'un écran de visualisation (4), ledit banc (1) comportant un moyen de surveillance optique (5) fixe de données affichées sur ledit écran de visualisation (4), et un organe de contrôle (6) relié audit moyen de surveillance optique (5), ledit banc (1) comportant une barre mobile (10) dans un plan (P1) en regard dudit équipement (2) apte à être déplacée selon une direction longitudinale (D1) perpendiculaire à ladite barre mobile (10) par un moyen de déplacement longitudinal (100), ledit banc (1) ayant un chariot mobile (20) soutenu par ladite barre mobile (10) par un moyen de déplacement transversal (200) apte à déplacer ledit chariot (20) le long de ladite barre mobile (10) dans ledit plan (P1),
**caractérisé en ce que**, ledit banc (1) est pourvu d'un bras rotatif (40) et d'un moyen de déplacement rotatif (400) pour faire tourner ledit bras rotatif (40) autour d'un axe de rotation (AX1) perpendiculaire audit plan (P1), un actionneur (50) desdits boutons (3) étant solidaire en rotation dudit bras rotatif (40) autour dudit axe de rotation (AX1) ; ledit bras rotatif (40) étant fixé à un support (30), le banc (1) comportant un moyen de translation (300) pour faire coulisser le support (30) sur ledit chariot (20) selon une direction de coulissement (D3) parallèle audit axe de rotation (AX1)ledit actionneur (50) comportant un bras allongé (501) solidarisé audit bras rotatif (40), ledit bras allongé (501) portant un carter (502) cylindrique muni d'une pluralité de pinces (503) mobiles par rapport audit carter (502), un premier moyen d'entraînement (504) commandant la mobilité desdites pinces (503) par une vis sans fin principale (506) s'étendant le long d'un axe de symétrie (AX2) dudit carter (502) et un deuxième moyen d'entraînement (505) commandant une rotation dudit carter (502) et desdites pinces (503) autour dudit axe de symétrie (AX2).

2. Banc de test selon la revendication 1,
**caractérisé en ce qu'**il comporte un premier montant (61) fixe de maintien latéral perpendiculaire à ladite barre mobile (10) et un deuxième montant (62) fixe latéral perpendiculaire à ladite barre mobile (10), une première extrémité (10') de la barre mobile (10) coulissant sur le premier montant (61) fixe et une deuxième extrémité (10") de la barre mobile (10) coulissant sur le deuxième montant (62) fixe, ledit moyen de déplacement longitudinal (100) déplaçant ladite barre mobile (10) par rapport aux premier et deuxième montants (61, 62) fixes selon ladite direction longitudinale (D1).

3. Banc de test selon l'une quelconque des revendications 1 à 2,
**caractérisé en ce que** chaque pince (503) est articulée d'une part au carter (502) par un axe de basculement (502') et, d'autre part, à un bras radial (507') d'un moyeu fileté (507) coulissant le long de ladite vis sans fin principale (506) par un axe de commande (507"').

4. Banc de test selon la revendication 3,
**caractérisé en ce que** ledit axe de commande (507"') d'une pince (503) est disposé dans un orifice oblong (503"') ménagé dans une première zone extrémale (503') de ladite pince (503).

5. Banc de test selon l'une quelconque des revendications 1 à 4,
**caractérisé en ce que** chaque pince (503) comporte un moyen de préhension (508) articulé à une deuxième zone extrémale (503") de ladite pince (503).

6. Banc de test selon l'une quelconque des revendications 1 à 5,
**caractérisé en ce que** ledit carter (502) comporte un engrenage inférieur (509) en prise avec ledit deuxième moyen d'entraînement (505), ladite vis sans fin principale (506) traversant ledit engrenage inférieur (509), ladite vis sans fin principale (506) et ledit engrenage inférieur (506) étant libres d'effectuer un mouvement indépendamment l'un de l'autre.

7. Banc de test selon l'une quelconque des revendications 1 à 6,
**caractérisé en ce que** lesdites pinces (503) sont réparties de manière équidistante sur une périphérie (502") dudit carter (502).

## Claims

1. Bench (1) for testing equipment (2) provided with a plurality of buttons (3) and a display screen (4), said bench (1) comprising a fixed means (5) for optical monitoring of data displayed on said display screen (4), and a control unit (6) connected to said optical monitoring means (5), said bench (1) comprising a bar (10) movable in a plane (P1) opposite said equipment (2) and displaceable in a longitudinal direction (D1) perpendicular to said movable bar (10) by a longitudinal-displacement means (100), said bench (1) having a movable carriage (20) supported by said movable bar (10) by a transverse-displacement means (200) capable of displacing said carriage (20) along said movable bar (10) in said plane (P1),
**characterised in that** said bench (1) is provided with a rotary arm (40) and with a rotary-displacement means (400) for rotating said rotary arm (40) about an axis of rotation (AX1) perpendicular to said plane (P1), an actuator (50) of said buttons (3) being integral in rotation with said rotary arm (40) about said axis of rotation (AX1); said rotary arm (40) being fixed to a support (30), the bench (1) comprising a translation means (300) for sliding the support (30) on said carriage (20) in a sliding direction (D3) parallel to said axis of rotation (AX1); said actuator (50) comprising an elongate arm (501) secured to said rotary arm (40), said elongate arm (501) carrying a cylindrical housing (502) equipped with a plurality of grippers (503) movable with respect to said housing (502), a first drive means (504) controlling the movability of said grippers (503) via a main endless screw (506) extending along an axis of symmetry (AX2) of said housing (502) and a second drive means (505) controlling a rotation of said housing (502) and of said grippers (503) about said axis of symmetry (AX2).

2. Test bench according to Claim 1,
**characterised in that** it comprises a first fixed lateral holding member (61) perpendicular to said movable bar (10) and a second fixed lateral member (62) perpendicular to said movable bar (10), a first end (10') of the movable bar (10) sliding on the first fixed member (61) and a second end (10") of the movable bar (10) sliding on the second fixed member (62), said longitudinal-displacement means (100) displacing said movable bar (10) with respect to the fixed first and second members (61, 62) in said longitudinal direction (D1).

3. Test bench according to any one of Claims 1 to 2,
**characterised in that** each gripper (503) is articulated, on the one hand, to the housing (502) by a tilt pin (502') and, on the other hand, to a radial arm (507') of a threaded hub (507) sliding along said main endless screw (506) by a control pin (507 " ').

4. Test bench according to Claim 3,
**characterised in that** said control pin (507 " ') of a gripper (503) is arranged in an oblong orifice (503"') formed in a first end zone (503') of said gripper (503).

5. Test bench according to any one of Claims 1 to 4, **characterised in that** each gripper (503) comprises a grasping means (508) articulated to a second end zone (503") of said gripper (503).

6. Test bench according to any one of Claims 1 to 5,
**characterised in that** said housing (502) comprises a lower gear (509) in engagement with said second drive means (505), said main endless screw (506) passing through said lower gear (509), said main endless screw (506) and said lower gear (506) [sic] being free to move independently of one another.

7. Test bench according to any one of Claims 1 to 6,
**characterised in that** said grippers (503) are distributed equidistantly on a periphery (502") of said housing (502).

## Patentansprüche

1. Prüfstand (1) für eine Ausrüstung (2), die mit einer Mehrzahl von Knöpfen (3) und einem Anzeigebildschirm (4) ausgestattet ist, mit einem feststehenden optischen Überwachungsmittel (5) von auf dem Anzeigebildschirm (4) dargestellten Daten und einem Steuerorgan (6), welches mit dem optischen Überwachungsmittel (5) verbunden ist, wobei der Prüfstand (1) eine in einer Ebene (P1) gegenüber der Ausrüstung (2) bewegliche Schiene (10) aufweist, die in einer Längsrichtung (D1) senkrecht zu der beweglichen Schiene (2) durch ein Längsverschiebungsmittel (100) bewegt werden kann, wobei der Prüfstand (1) einen beweglichen Schlitten (20) aufweist, der von der beweglichen Schiene (10) über ein Querverschiebungsmittel (200) gehalten wird, welches den Schlitten (20) entlang der beweglichen Schiene (10) in dieser Ebene (P1) bewegen kann,
**dadurch gekennzeichnet, dass** der Prüfstand (1) mit einem Dreharm (40) und einem Drehantriebsmittel (400) versehen ist, um den Dreharm (40) um eine Drehachse (AX1) zu drehen, die senkrecht zu der Ebene (P1) verläuft, wobei ein Gerät (50) zur Betätigung der Knöpfe (3) drehfest mit dem um die Drehachse (AX1) drehbaren Arm (40) verbunden ist, wobei der Dreharm (40) an einem Träger (30) befestigt ist, und die Prüfbank (1) ein Translationsbewegungsmittel (300) aufweist, um den Träger (30) auf dem Schlitten (20) entlang einer Gleitrichtung (D3) gleiten zu lassen, die parallel zu der Drehachse (AX1) verläuft, wobei das Betätigungsgerät (50) einen verlängerten Arm (501) aufweist, der an dem Dreharm (40) befestigt ist, der verlängerte Arm (501) ein zylinderförmiges Gehäuse (502) trägt, welches mit einer Mehrzahl von Zangen (503) versehen ist, die gegenüber dem Gehäuse (502) beweglich sind, ein erstes Antriebsmittel (504), welches die Beweglichkeit der Zangen (503) durch eine Haupt-Endlosschraube (506) steuert, die sich entlang einer Symmetrieachse (AX2) des Gehäuses (502) erstreckt, und ein zweites Antriebsmittel (505) aufweist, welches eine Drehung des Gehäuses (502) und der Zangen (503) um die Symmetrieachse (AX2) steuert.

2. Prüfstand nach Anspruch 1,
**dadurch gekennzeichnet, dass** er einen ersten festen Ständer (61) zur seitlichen Halterung senkrecht zu der beweglichen Schiene (10) aufweist, sowie einen zweiten festen seitlichen Ständer (62) senkrecht zu der beweglichen Schiene (10) aufweist, wobei ein erstes Ende (10') der beweglichen Schiene (10) auf dem ersten festen Ständer (61) gleitet und ein zweites Ende (10") der beweglichen Schiene (10) auf dem zweiten festen Ständer (62) gleitet, wobei das Längsbewegungsmittel (100) die bewegliche Schiene (10) relativ zu den ersten und zweiten festen Ständern (61, 62) entlang der Längsrichtung (D1) bewegt.

3. Prüfstand nach einem der Ansprüche 1 oder 2,
**dadurch gekennzeichnet, dass** jede Zange (503) einerseits am Gehäuse (502) über eine Schwenkachse (502') und andererseits an einem Radialarm (507') einer Gewindenabe (507) angelenkt ist, die entlang der Haupt-Endlosschraube (506) auf einer Steuerachse (507"') gleitet.

4. Prüfstand nach Anspruch 3,
**dadurch gekennzeichnet, dass** die Steuerachse (507"') einer Zange (503) in einem Langloch (503"') angeordnet ist, welches in einem ersten Endbereich (503') der Zange (503) eingearbeitet ist.

5. Prüfstand nach einem der Ansprüche 1 bis 4,
**dadurch gekennzeichnet, dass** jede Zange (503) ein Greifmittel (508) aufweist, welches in einem zweiten Endbereich (503") der Zange (503) angelenkt ist.

6. Prüfstand nach einem der Ansprüche 1 bis 5,
**dadurch gekennzeichnet, dass** das Gehäuse (502) ein unteres Stirnrad (509) aufweist, welches mit dem zweiten Antriebsmittel (505) in Eingriff steht, wobei die Haupt-Endlosschraube (506) das untere Stirnrad (509) durchquert, wobei die Haupt-Endlosschraube (506) und das untere Stirnrad (506) sich voneinander unabhängig frei bewegen können.

7. Prüfstand nach einem der Ansprüche 1 bis 6,
**dadurch gekennzeichnet, dass** die Zangen (503) gleich beabstandet auf einem Rand (502") des Gehäuses (502) angeordnet sind.
